# EUROPÄISCHE PATENTSCHRIFT

(11) **EP 1 748 466 B1**
(45) Veröffentlichungstag und Bekanntmachung des Hinweises auf die Patenterteilung: **19.03.2008**
(21) Anmeldenummer: 05016486.2
(22) Anmeldetag: 29.07.2005
(51) Int. Cl.: H01L 21/00

(54) **Vorrichtung zur Oberflächenreinigung von Wafern**
Wafer surface cleaning device
Dispositif pour le nettoyage de surfaces de plaquettes semiconductrices

(43) Veröffentlichungstag der Anmeldung: 31.01.2007
(73) Patentinhaber: Thallner, Aya Maria, 4782 St. Florian (AT)
(72) Erfinder: Thallner, Aya Maria, 4782 St. Florian (AT)
(74) Vertreter: Schweiger, Johannes

(56) Entgegenhaltungen:
- WO-A-00/59006
- DE-A1- 19 629 705
- US-A1- 2001 010 103
- US-A1- 2004 025 911

## Beschreibung

Die Erfindung betrifft eine Vorrichtung zur Oberflächenreinigung von Wafern, insbesondere SOI-Wafern (silicon on insulator), durch Beaufschlagung der zu reinigenden Waferoberfläche mit einer Reinigungsflüssigkeit.

Die SOI-Technologie ist eine aufwendige Bauart für Schaltkreise aus Siliziumtransistoren: diese befinden sich auf einem isolierenden Material, wodurch sich kürzere Schaltzeiten und geringere Leistungsaufnahmen ergeben.

Im Gegensatz zu gewöhnlichen Transistoren, die direkt auf dem Siliziumwafer gefertigt werden, haben die Transistoren auf einer Isolatorschicht eine geringere Kapazität, so dass die bis zum Schalten benötigten Ladungen verringert werden. Durch die so verringerten Schaltzeiten werden also höhere Taktraten ermöglicht. Gleichzeitig wird die Leistungsaufnahme verringert, wodurch sich auch kleinere Verlustwärmen ergeben. Ein Vorteil ist die geringere Empfindlichkeit gegenüber ionisierender Strahlung.

Zur Herstellung muss man entweder eine dünne Siliziumschicht auf ein isolierendes Material, bevorzugt auf Saphir, auftragen, oder eine isolierende Schicht aus Siliziumdioxid in ein Siliziumkristall einbringen. Eine weitere Methode ist das sogenannte Bonden: hierfür wird ein SI-Wafer thermisch oxidiert, dann wird ein zweiter mit seiner einkristallinen Oberfläche auf dessen Oxidschicht gelegt. Weitere Prozesse trennen den zweiten Wafer bis auf wenige Mikrometer ab.

Für die Herstellung von SOI-Wafern ist es notwendig, die Oberfläche der Wafer zu reinigen und/oder zu aktivieren und/oder zu hydrophilisieren.

Diese Reinigung und/oder Hydrophilisierung wird bei den gattungsgemäßen Vorrichtungen über die Zuführung von DI (deionisiertem)-Wasser auf die Oberfläche des Wafers erreicht. Die Reinigungswirkung wird teilweise unter Zuhilfenahme einer speziellen Bürste oder durch Einsatz von mittels Piezoschwingern angeregtem DI-Wasser verbessert, das über eine mit einer Frequenz von einigen kHz bis 1 MHz schwingenden Düse zugeführt wird. Hierdurch wird der DI-Wasserstrahl, der auf die Waferoberfläche aufgebracht wird, mit dieser Schwingungsenergie beaufschlagt.

Solche Verfahren/Vorrichtungen sind in der DE 19629705A1, der US 2001/010103A1 und der US 2004/025911A1 gezeigt.

Die Aufgabe der vorliegenden Erfindung ist es, eine Vorrichtung vorzugeben, die eine bessere Reinigungswirkung erzielt und den Wafer dabei gleichmäßiger reinigt.

Grundidee zur Lösung der vorstehenden Aufgabe im Rahmen der vorliegenden Erfindung ist es, die Reinigungsflüssigkeit auf der Waferoberfläche durch entsprechende tortenförmige Mittel zur Schwingungsanregung mit einer Schwingungsenergie zu beaufschlagen. Hierfür sind Mittel zur Schwingungsanregung vorgesehen, die unmittelbar auf die auf dem Wafer befindliche Reinigungsflüssigkeit einwirken.

Auf Grund der Scheibenform des Wafers ist es besonders vorteilhaft, wenn die Mittel zur Schwingungsanregung relativ-rotatorisch über der Waferoberfläche angeordnet sind, wodurch die Mittel zur Schwingungsanregung nur einen Teilbereich der Waferoberfläche abdecken müssen und trotzdem die gesamte Oberfläche gereinigt werden kann.

Zur Einbringung der Schwingungsenergie in die auf dem Wafer befindliche Reinigungsflüssigkeit eignen sich besonders Piezoschwinger, die in geringem Abstand über der Waferoberfläche angeordnet sind. Der/die Piezoschwinger können dabei freischwebend über der Waferoberfläche angeordnet sein und durch einen Schwingarm mit einem Gehäuse 9 der Vorrichtung zur Oberflächenreinigung verbunden sein.

Durch die tortenförmige Ausgestaltung des/der Piezoschwinger kann eine besonders gleichmäßige Verteilung der Schwingungsenergie über die Waferoberfläche erreicht werden, da hierdurch die runde Form der Wafer Berücksichtigung findet und somit in einer Umdrehung des Wafers über die gesamte Oberfläche nahezu die selbe Energie eingebracht werden kann.

Durch die Tortenform ist es weiterhin möglich, mehrere Piezoschwinger in benachbarten Segmenten über der Waferoberfläche anzuordnen. Durch diese Ausgestaltung wird die Möglichkeit eröffnet, die Piezoschwinger einerseits hinsichtlich der Schwingungsfrequenz, der geometrischen Ausgestaltung/Anordnung bzw. des jeweiligen dynamischen Verlaufes unterschiedlich arbeiten zu lassen und andererseits durch Ausbildung eines Spaltes zwischen benachbarten Piezoschwingern die Einbringung von Gasen, freien Radikalen und/oder Flüssigkeiten in diesem Spalt zur Aktivierung bzw. Hydrophysierung der Wafer zu ermöglichen. Dadurch kann in einem Arbeitsschritt sowohl eine Reinigung als auch eine Aktivierung der Waferoberfäche erfolgen.

Indem der Spalt/die Kammer mit einer flexiblen Folie als Dach/Überstand verbunden ist, wird einerseits ein Austrag von Reinigungsflüssigkeit verhindert und andererseits eine unabhängige Regelung und Schwingung der Piezoschwinger ermöglicht.

Der Eintrag von Gasen, freien Radikalen und/oder Flüssigkeiten in den zwischen den Piezoschwingern gebildeten Raum erfolgt durch Öffnungen in der flexiblen Folie und daran angeschlossene Leitungen bzw. Schläuche.

Weiterhin ist es von Vorteil, wenn die über der Waferoberfläche schwebenden Piezoschwinger in der Höhe verstellbar sind und damit ebenfalls unterschiedliche Reinigungswirkungen erzielt werden können. Die Einstellung der Höhe erfolgt in vorteilhafter Weise an einem Schwingungsarm, mit welchem der jeweilige Piezoschwinger an dem Gehäuse der Vorrichtung angebracht ist. Die Verstellung kann auch durch einen Elektromotor und in dynamischer Weise auch durch eine Steuereinheit geregelt erfolgen.

Die Steuereinrichtung kann daneben auch die Schwingungsfrequenzen der Piezoschwinger dynamisch anpassen oder über einen bestimmten Bereich während des Reinigungsprozesses verändern, um unterschiedliche Umgebungsbedingungen bzw. Materialbeschaffenheiten zu berücksichtigen.

Die Vorrichtung kann auch so ausgestaltet sein, dass das Gehäuse der Vorrichtung die anderen Baugruppen umschließt und Gase und/oder freie Radikale und/oder Flüssigkeiten in das Gehäuse über eine daran angeschlossene Zuführeinrichtung eingeleitet werden.

Die Erfindung wird nun anhand eines Ausführungsbeispiels näher beschrieben, wobei die Zeichnung durch folgende Figuren gebildet wird, in welchen gleiche Bauteile mit gleichen Bezugszeichen gekennzeichnet sind:
- Fig. 1:: schematische Seitenansicht der erfindungsgemäßen Vorrichtung;
- Fig. 2:: schematische Vorderansicht der erfindungsgemäßen Vorrichtung;
- Fig. 3:: perspektivische Ansicht der erfindungsgemäßen Vorrichtung.

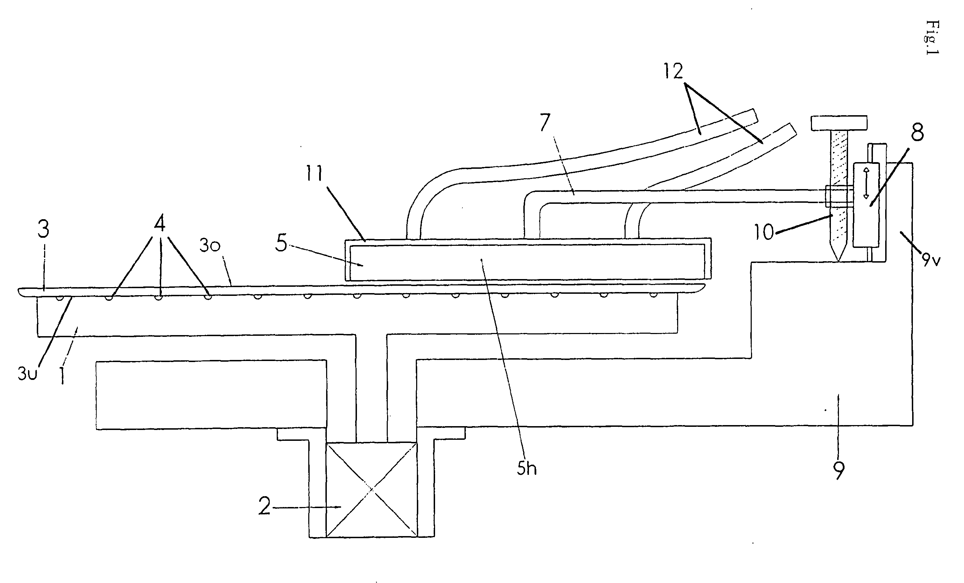

Fig. 1 zeigt eine Aufnahmeeinrichtung 1, die hier als Chuck 1 ausgebildet ist. Der Chuck 1 wird durch einen Motor 2, vorzugsweise ein Elektromotor, in Rotation versetzt. Auf dem Chuck 1 befindet sich ein Wafer 3 mit einer Waferoberfläche 3o und einer der Waferoberfläche abgewandten Seite 3u. Der Wafer 3 ist mit seiner der Waferoberfläche 3o abgewandten Seite 3u durch mit Vakuum/Unterdruck beaufschlagte Vakuumbahnen 4 auf dem Chuck 1 festlegbar, indem ein Unterdruck für die Ansaugung des Wafers 3 in Richtung der Aufnahmeeinrichtung 1 (Chuck) sorgt.

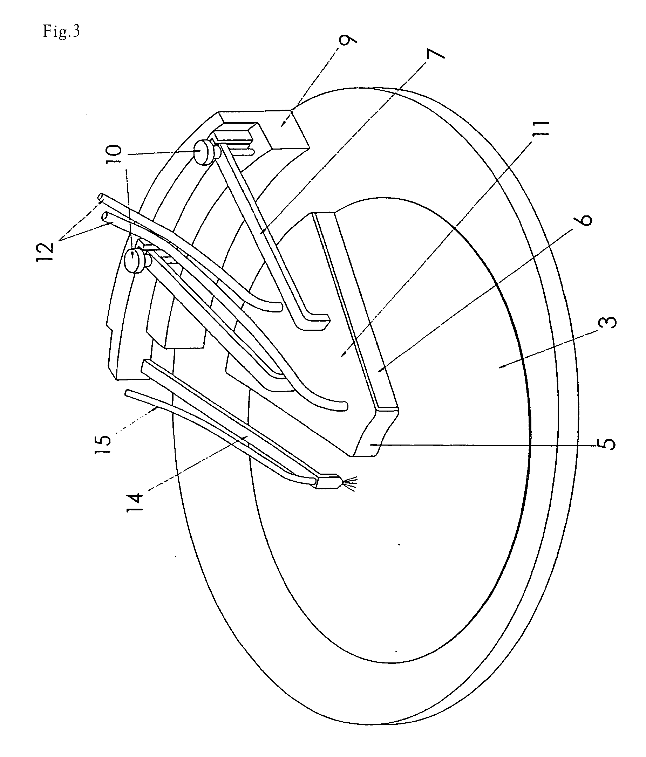

Oberhalb des Wafers 3 befinden sich zwei Piezoschwinger 5 und 6, die eine in Fig. 3 gut erkennbare Tortenform aufweisen und durch eine Halterung 7 mit einer Führung 8 an dem Gehäuse 9 angebracht sind. Durch eine Mikrometerschraube 10 können die Piezoschwinger 5, 6 unabhängig voneinander in einem definierten Abstand zu der Waferoberfläche 3o des Wafers 3 angeordnet werden und sind in der Höhe verschiebbar. Die Verstellung der Mikrometerschraube 10 kann auch elektromotorisch erfolgen.

Die Mittel zur Schwingungsanregung sind im Wesentlichen durch eine flexible Folie 11 gebildet, durch die ein in Richtung der Waferoberfläche 3o zeigender Hohlraum 5h gebildet wird, der zur Abdeckung der Piezoschwinger 5, 6 dient. Zwischen den beiden Piezoschwingern 5 und 6 entsteht durch einen Spalt eine mit der flexiblen Folie 11 nach oben verschlossene Kammer 13, in welche über Schläuche 12 Gase, freie Radikale und/oder Flüssigkeiten eingeleitet werden können. Die Folie 11 verschließt den Spalt/die Kammer 13 zwischen den Piezoschwingern 5 und 6 auch zu den offenen Seiten hin.

In das Gehäuse 9 ist einerseits der an sich bekannte Chuck 1 integriert, der für die Aufnahme und Rotierung des Wafers 3 verantwortlich ist. Seitlich vom Wafer 3 weist das Gehäuse 9 einen Vorsprung 9v auf, an welchem über eine an dem Vorsprung 9v geführte und senkrecht verfahrbare Führung 8 die Halterungen 7 und je ein Piezoschwinger 5, 6 angebracht sind.

Die Piezoschwinger 5, 6 sind durch Wirkverbindungen 5w, 6w jeweils mit einer nicht dargestellten Steuereinheit zur Erzeugung der Schwingungsfrequenz verbunden, wodurch jeder Piezoschwinger 5, 6 mit einer individuellen Schwingungsfrequenz beaufschlagt werden kann. Die Steuereinheit dient auch zur Steuerung der Motordrehzahl des Motors 2 sowie zur Regelung verschiedener, nicht dargestellter Ventile zur Medienzuführung über die Schläuche 12 in den Spalt zwischen den Piezoschwingern 5 und 6. Weiterhin wird durch die Steuereinheit auch die Mikrometerschraube 10 bzw. eine entsprechende motorische Verstelleinheit jeder Halterung 7 der Piezoschwinger 5, 6 gesteuert und damit der Abstand der Piezoschwinger 5, 6 zur Waferoberfläche 3o eingestellt

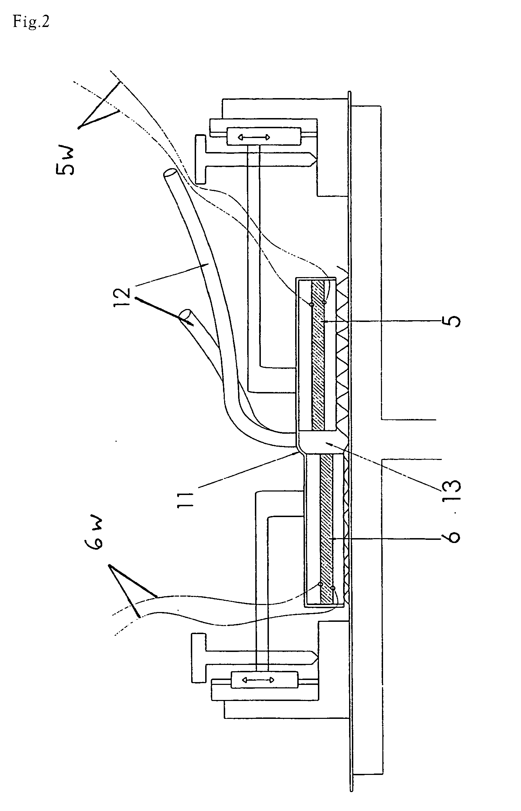

Das in Fig. 2 dargestellte Schwingelement 5, 6 jedes Piezoschwingers 5, 6 ist als zwischen einer Montageplatte befindlicher schwingungsgebender Kristall ausgebildet. Unter dem Kristall kann ein weiteres Material aufgebracht sein, um den Kristall zu schützen. Diese Element sind in einer elastischen Masse vergossen, um die Schwingungen übertragen zu können.

In Fig. 3 ist weiterhin eine Düse 14 mit einem daran angebrachten Schlauch 15 gezeigt, die für die Aufbringung von Reinigungsflüssigkeit RF auf den Wafer 3 Sorge trägt. Die Reinigungsflüssigkeit RF kann zusätzlich zu den Piezoschwingern 5, 6 bereits im Vorfeld mit Schwingungsenergie versehen worden sein. Weiterhin kann die Reinigung auch noch zusätzlich durch Bürsten verstärkt werden.

Demnach ist mit der vorliegenden Vorrichtung eine gleichzeitige Reinigung, Hydrophilisierung sowie Aktivierung der Waferoberfläche 3o möglich. Die Steuereinheit kann dabei für einen bestimmten Verfahrensablauf zur Reinigung des Wafers sorgen, indem sie folgende Schritte in der angegebenen Reihenfolge ausführt, wobei bestimmte Schritte auch parallel/überschneidend ausgeführt werden können:
- Aufnahme des Wafers 3 auf der Aufnahmeeinrichtung 1, wobei die Waferoberfläche 3o von der Aufnahmeeinrichtung 1 abgewandt ist.
- Beaufschlagung der Vakuumbahnen 4 mit Unterdruck/Vakuum.
- Rotation der Aufnahmeeinrichtung 1 mittels Motor 2.
- Aufbringen der Reinigungsflüssigkeit RF mittels Düse 14 über Schlauch 15, wobei die Reinigungsflüssigkeit RF insbesondere mit einer Schwingungsfrequenz angeregt werden kann.
- Aktivierung der Piezoschwinger 5, 6, insbesondere mit einem bestimmten, dynamischen und voneinander unabhängigen Frequenzprogramm in einem Schwingungsfrequenzbereich von 1 kHz bis 100 MHz, insbesondere 10 kHz bis 10 MHz.
- Gegebenenfalls Einleiten von Gasen und/oder freien Radikalen und/oder Flüssigkeiten in die Kammer 3 zwischen dem Piezoschwinger 5 und dem Piezoschwinger 6 zur Aktivierung der Waferoberfläche 30.

### Bezugszeichenliste

- 1: Chuck
- 2: Motor
- 3: Wafer
- 3o: Waferoberfläche
- 3u: abgewandte Seite
- 4: Vakuumbahn
- 5: Piezoschwinger
- 5h: Hohlraum
- 5w: Wirkverbindung
- 6: Piezoschwinger
- 6h: Hohlraum
- 6w: Wirkverbindung
- 7: Halterung
- 8: Führung
- 9: Gehäuse
- 9v: Vorsprung
- 10: Mikrometerschraube
- 11: flexible Folie
- 12: Schlauch
- 13: Kammer
- 14: Düse
- 15: Schlauch
- RF: Reinigungsflüssigkeit

## Patentansprüche

1. Vorrichtung zur Oberflächenreinigung von Wafern (3), insbesondere SOI-Wafern, durch Beaufschlagung der zu reinigenden Waferoberflächen (30) mit einer Reinigungsflüssigkeit RF, **dadurch gekennzeichnet, dass** mindestens ein tortenförmiges Mittel zur Schwingungsanregung (5, 6) der Reinigungsflüssigkeit RF auf dem Wafer (3) vorgesehen ist.

2. Vorrichtung nach Anspruch 1, bei der die Mittel zur Schwingungsanregung (5, 6) relativ-rotatorisch über der Waferoberfläche (30) angeordnet sind.

3. Vorrichtung nach Anspruch 1, bei der die Mittel zur Schwingungsanregung (5, 6) als Piezoschwinger ausgebildet sind.

4. Vorrichtung nach Anspruch 1, bei der die Mittel zur Schwingungsanregung (5,6) parallel zur Waferoberfläche (3o) angeordnet sind.

5. Vorrichtung nach Anspruch 1, bei der die Mittel zur Schwingungsanregung (5, 6) sich über einen vorgegebenen Winkelbereich der Waferoberfläche (30) erstrecken.

6. Vorrichtung nach Anspruch 1, bei der die Mittel zur Schwingungsanregung einen in Richtung der Waferoberfläche (30) gerichteten Hohlraum (5h, 6h) bilden, in welchem die Schwingungsanregung der Reinigungsflüssigkeit erfolgt.

7. Vorrichtung nach einem der vorhergehenden Ansprüche, bei der der Wafer (3)
- mit seiner der Waferoberfläche (3o) abgewandten Seite (3u) auf einer mit Vakuumbahnen (4) versehenen Aufnahmeeinrichtung (1) festlegbar ist,
- durch einen Motor (2) mit der Aufnahmeeinrichtung (1) relativ zu einem Gehäuse (9) rotierbar ist, an welchen die Mittel zur Schwingungsanregung (5, 6) angebracht sind.

8. Vorrichtung nach Anspruch 1, bei der zwei unabhängig voneinander betreibbare Piezoschwinger (5, 6) vorgesehen sind.

9. Vorrichtung nach Anspruch 1, bei der die Piezoschwinger (5, 6) in der Höhe verstellbar an dem Gehäuse (9), insbesondere an einem Vorsprung (9v) des Gehäuses (9) angebracht sind.

10. Vorrichtung nach Anspruch 9, bei der mindestens einer der Piezoschwinger (5, 6) über eine Mikrometerschraube (10) verstellbar ist.

11. Vorrichtung nach Anspruch 9, bei der die Piezoschwinger (5, 6) während dem Reinigungsvorgang des Wafers (3) dynamisch verstellbar sind, insbesondere durch einen von einer Steuereinrichtung gesteuerten Elektromotor.

12. Vorrichtung nach Anspruch 1, bei der die durch eine Düse (14) aufzubringende Reinigungsflüssigkeit RF bei der Aufbringung auf den Wafer (3) durch eine Düse (14) anregbar ist.

13. Vorrichtung nach Anspruch 1, bei der mindestens zwei Mittel zur Schwingungsanregung (5, 6) durch eine flexible Folie (11) miteinander verbunden sind, wobei die Folie (11) als Abdeckung der Mittel zur Schwingungsanregung (5, 6) dient.

14. Vorrichtung nach Anspruch 1, bei der die Mittel zur Schwingungsanregung (5, 6) mit je einer Schwingungsfrequenz in einem Frequenzbereich von 1 kHz bis 100 MHz, insbesondere 10 kHz bis 10 MHz schwingen.

15. Vorrichtung nach Anspruch 1, bei der mindestens zwei Mittel zur Schwingungsanregung (5, 6) mit unterschiedlichen Schwingungsfrequenzen schwingen.

16. Vorrichtung nach Anspruch 1, bei der die Schwingungsfrequenzen der Mittel zur Schwingungsanregung (5, 6) dynamisch und/oder unabhängig voneinander veränderbar sind.

17. Vorrichtung nach Anspruch 1, bei der zwischen den mindestens zwei Mitteln zur Schwingungsanregung (5, 6) mindestens ein Spalt zur Bildung einer Kammer (13) vorgesehen ist mit mindestens einer Zuführeinrichtung (12) zum Einleiten von Gasen und/oder freien Radikalen und/oder Flüssigkeiten in die Kammer (13).

18. Vorrichtung nach Anspruch 1, bei der die Vorrichtung ein Gehäuse (9) umfasst, das den Wafer (3) und die Mittel zur Schwingungsanregung (5, 6) umschließt, wobei mindestens eine Zuführeinrichtung zum Einleiten von Gasen und/oder freien Radikalen und/oder Flüssigkeiten in das Gehäuse (9) an dem Gehäuse vorgesehen ist.

19. Vorrichtung nach Anspruch 18, bei der die Zuführeinrichtung aus Düsen und/oder Zuführungsrohren und/oder Ventilen besteht.

20. Vorrichtung nach Anspruch 1, bei der die Waferoberfläche 30 vollflächig mit Mitteln zur Schwingungsanregung (5, 6) abgedeckt ist.

## Claims

1. Device for cleaning the surface of wafers (3), particularly SOI wafers, by applying a cleaning fluid RF to the wafer surfaces (30) to be cleaned, **characterized in that** at least one cake-shaped means for stimulating oscillation (5, 6) of the cleaning fluid RF is provided on the wafer (3).

2. Device according to Claim 1, wherein the means for stimulating oscillation (5, 6) are arranged relatively rotatorily over the wafer surface (3o).

3. Device according to Claim 1, wherein the means for stimulating oscillation (5, 6) are in the form of a piezo-oscillator.

4. Device according to Claim 1, wherein the means for stimulating oscillation (5, 6) are arranged parallel to the wafer surface (30).

5. Device according to Claim 1, wherein the means for stimulating oscillation (5, 6) extend over a specified angular range of the wafer surface (30).

6. Device according to Claim 1, wherein the means for stimulating oscillation form a hollow space (5h, 6h) which is directed in the direction of the wafer surface (30), and in which the cleaning fluid is stimulated to oscillate.

7. Device according to one of the preceding claims, wherein the wafer (3)
- can be fixed with its side (3u) facing away from the wafer surface (30) on a receiving device (1) which is provided with vacuum tracks (4),
- can be rotated with the receiving device (1) by a motor (2) relative to a housing (9), to which the means for stimulating oscillation (5, 6) are attached.

8. Device according to Claim 1, wherein two piezo-oscillators (5, 6), which can be operated independently of each other, are provided.

9. Device according to Claim 1, wherein the piezo-oscillators (5, 6) are height adjustable attached to the housing (9), in particular on a projection (9v) of the housing (9) .

10. Device according to Claim 9, wherein at least one of the piezo-oscillators (5, 6) is adjustable by means of a micrometer screw (10).

11. Device according to Claim 9, wherein the piezo-oscillators (5, 6) can be adjusted dynamically, in particular by an electric motor which is controlled by a controller, while the wafer (3) is being cleaned.

12. Device according to Claim 1, wherein the cleaning fluid RF which is to be applied through a jet (14) can be stimulated by a jet (14) when it is applied to the wafer (3).

13. Device according to Claim 1, wherein at least two means for stimulating oscillation (5, 6) are connected to each other by a flexible foil (11), the foil (11) being used to cover the means for stimulating oscillation (5, 6).

14. Device according to Claim 1, wherein the means for stimulating oscillation (5, 6) each oscillate at an oscillation frequency in a frequency range from 1 kHz to 100 MHz, in particular 10 kHz to 10 MHz.

15. Device according to Claim 1, wherein at least two means for stimulating oscillation (5, 6) oscillate at different oscillation frequencies.

16. Device according to Claim 1, wherein the oscillation frequencies of the means for stimulating oscillation (5, 6) can be changed dynamically and/or independently of each other.

17. Device according to Claim 1, wherein between the at least two means for stimulating oscillation (5, 6) at least one gap to form a chamber (13) is provided, with at least one feed device (12) to introduce gases and/or free radicals and/or fluids into the chamber (13).

18. Device according to Claim 1, wherein the device includes a housing (9), which encloses the wafer (3) and the means of stimulating oscillation (5, 6), at least one feed device to introduce gases and/or free radicals and/or fluids into the housing (9) being provided on the housing.

19. Device according to Claim 18, wherein the feed device consists of jets and/or feed pipes and/or valves.

20. Device according to Claim 1, wherein the wafer surface 30 is completely covered by means of stimulating oscillation (5, 6).

## Revendications

1. Dispositif destiné au nettoyage de surfaces de plaquettes semi-conductrices (3), en particulier des plaquettes de silicium sur isolant, au moyen de l'application d'un liquide de nettoyage RF sur les surfaces (30) des plaquettes à nettoyer, **caractérisé en ce qu'**au moins un moyen (5, 6) en forme de camembert destiné à générer des oscillations du liquide de nettoyage RF est prévu sur la plaquette semi-conductrice (3).

2. Dispositif selon la revendication 1, dans lequel les moyens (5, 6) destinés à générer des oscillations sont agencés de manière à effectuer une rotation relative au-dessus de la surface de plaquette (30).

3. Dispositif selon la revendication 1, dans lequel les moyens (5, 6) destinés à générer des oscillations sont réalisés sous la forme d'oscillateurs piézoélectriques.

4. Dispositif selon la revendication 1, dans lequel les moyens (5, 6) destinés à générer des oscillations sont agencés parallèlement à la surface de plaquette (30).

5. Dispositif selon la revendication 1, dans lequel les moyens (5, 6) destinés à générer des oscillations s'étendent sur une zone angulaire prédéfinie de la surface de plaquette (30).

6. Dispositif selon la revendication 1, dans lequel les moyens destinés à générer des oscillations forment une cavité (5h, 6h), qui est orientée dans la direction de la surface de plaquette (30) et dans laquelle le liquide de nettoyage subit des oscillations.

7. Dispositif selon l'une quelconque des revendications précédentes, dans lequel la plaquette semi-conductrice (3)
- avec sa face (3u) détournée de la surface de plaquette (3o) peut être fixée sur un dispositif de réception (1) muni de pistes sous vide (4),
- peut être entraîné en rotation avec le dispositif de réception (1) au moyen d'un moteur (2) par rapport à un boîtier (9), sur lequel sont montés les moyens (5, 6) destinés à générer des oscillations.

8. Dispositif selon la revendication 1, dans lequel il est prévu deux oscillateurs piézoélectriques (5, 6) indépendants l'un de l'autre.

9. Dispositif selon la revendication 1, dans lequel les oscillateurs piézoélectriques (5, 6) sont montés de manière réglable en hauteur contre le boîtier (9), en particulier contre une saillie (9v) du boîtier (9).

10. Dispositif selon la revendication 9, dans lequel au moins un des oscillateurs piézoélectriques (5, 6) est réglable au moyen d'une vis micrométrique (10).

11. Dispositif selon la revendication 9, dans lequel, pendant le processus de nettoyage de la plaquette semi-conductrice (3), les oscillateurs piézoélectriques (5, 6) sont réglables par voie dynamique, en particulier par un moteur électrique commandé par un dispositif de commande.

12. Dispositif selon la revendication 1, dans lequel le liquide de nettoyage RF, à appliquer au moyen d'une buse (14), peut être stimulé au moment de l'application sur la plaquette semi-conductrice (3) au moyen d'une buse (14).

13. Dispositif selon la revendication 1, dans lequel au moins deux moyens (5, 6) destinés à générer des oscillations sont reliés entre eux par une feuille (11) flexible, la feuille (11) étant destinée à recouvrir les moyens (5, 6) destinés à générer des oscillations.

14. Dispositif selon la revendication 1, dans lequel les moyens (5, 6) destinés à générer des oscillations oscillent chacun avec une fréquence d'oscillation dans un domaine de fréquences de 1 kHz à 100 MHz, en particulier de 10 kHz à 10 MHz.

15. Dispositif selon la revendication 1, dans lequel au moins deux moyens (5, 6) destinés à générer des oscillations oscillent avec des fréquences d'oscillation différentes.

16. Dispositif selon la revendication 1, dans lequel les fréquences d'oscillation des moyens (5, 6) destinés à générer des oscillations peuvent être modifiées par voie dynamique et/ou indépendamment les unes des autres.

17. Dispositif selon la revendication 1, dans lequel entre lesdits au moins deux moyens (5, 6) destinés à générer des oscillations il est prévu au moins une fente destinée à former une chambre (13) avec au moins un dispositif d'admission (12) pour l'entrée de gaz et/ou de radicaux libres et/ou de liquides dans la chambre (13).

18. Dispositif selon la revendication 1, dans lequel le dispositif comporte un boîtier (9), qui entoure la plaquette semi-conductrice (3) et les moyens (5, 6) destinés à générer des oscillations, au moins un dispositif d'admission étant prévu sur le boîtier (9) pour l'entrée de gaz et/ou de radicaux libres et/ou de liquides dans le boîtier (9).

19. Dispositif selon la revendication 18, dans lequel le dispositif d'admission est formé par des buses et/ou des tubes d'acheminement et/ou des soupapes.

20. Dispositif selon la revendication 1, dans lequel la surface de plaquette (3o) est couverte sur toute la surface par des moyens (5, 6) destinés à générer des oscillations.
